# EUROPEAN PATENT APPLICATION

(11) **EP 1 369 933 A2**
(43) Date of publication of application: **10.12.2003**
(21) Application number: 03012229.5
(22) Date of filing: 06.06.2003
(51) Int. Cl.: H01L 31/18, H01L 31/0392

(54) **Film forming method**

(30) Priority: 07.06.2002 JP 2002167124
(71) Applicant: FUJI PHOTO FILM CO., LTD., Kanagawa 250-01 (JP)
(72) Inventor: Shibata, Norio, Odawara-shi, Kanagawa (JP); Nakada, Junji, Odawara-shi, Kanagawa (JP); Fujinawa, Jun, Odawara-shi, Kanagawa (JP)
(74) Representative: HOFFMANN - EITLE

(57) **Abstract**

The film forming method first forms a film having at least one layer by a film forming process on a surface of a heat-resistant member having higher heat resistance than a substrate on which the film is to be formed and the film forming process includes a step of performing at a temperature higher than a heat resistance temperature of the substrate. The method thereafter transfers the film formed on the heat-resistant member to the surface of the substrate at a temperature less than the heat resistance temperature of the substrate.

## Description

### BACKGROUND OF THE INVENTION

This invention relates to the technical field of film formation and, more particularly, to a film forming method by which high-quality films generated through a process including a high-temperature step can be formed on non-heat resistant substrates such as plastic films.

Film forming processes are employed in a variety of applications including the formation of transparent electrodes as in the manufacture of liquid-crystal displays, the formation of light-emitting layers in the manufacture of organic EL (electroluminescence) displays, and the manufacture of magnetic recording media.

Known examples of such film forming processes include vacuum film forming processes (dry processes) such as sputtering, vacuum vapor deposition (evaporation) using resistance heating, EB heating or the like, ion plating and CVD, as well as wet film forming processes that comprise the steps of preparing a paint containing film forming materials, applying the paint to a film forming member, removing the solvent, and curing the paint by means of exposure to electron beams or uv radiation or sol/gel conversion.

While the dry and wet processes are entirely different as film forming approaches, it is common practice for both processes to form films directly on the substrate.

It is known with the vacuum film forming process that films of higher crystalinity and hence higher quality can be produced at higher temperatures than at lower temperatures. In film forming processes that involve high-temperature chemical reaction steps as exemplified by film formation through sol/gel conversion or from nanoparticles, films of higher quality can similarly be produced by performing the reaction at higher temperatures and chemical reactions such as sol/gel conversion may sometimes fail to proceed if the temperature is low. It is also known that even with a film forming process that does not involve film formation at higher temperatures, films formed may be subjected to a high-temperature treatment such as annealing to have higher quality.

Thus, in many film forming processes, films of higher quality can be formed by either increasing the deposition temperature or subjecting the formed film to a high-temperature treatment.

Consider, for example, a case where an indium-tin oxide film that is employed as a transparent electrode in liquid-crystal displays and the like is formed by the vacuum film forming process. In this process, a film formed under the high-temperature condition has better crystallinity than one formed under the low-temperature condition, eventually leading to the formation of a transparent electrode in the form of an indium-tin oxide film having lower electrical resistance.

This is also true with Co-Cr based magnetic films which are employed as magnetic layers in magnetic recording media such as hard discs; a film formed under the high-temperature condition has better crystallinity than one formed under the low-temperature condition and, eventually, the grains can be sufficiently reduced in size to enable the formation of a Co-Cr based magnetic film having better magnetic characteristics.

However, if substrates of low heat resistance such as plastic films are used as substrates in the above-described film forming processes, film formation cannot be performed at high temperature considering the thermal damage that will be caused to the substrate.

As a result, the films formed have lower performance than films formed on heat-resistant substrates under the high-temperature condition or those subjected to a high-temperature treatment after being formed.

### SUMMARY OF THE INVENTION

The present invention has been accomplished under those circumstances and has as an object providing a film forming method by which a film of high quality having high crystallinity that has been generated under the high-temperature condition and/or subjected to a high-temperature treatment can be formed with high efficiency on a surface of a film-forming substrate made of a non-heat resistant material such as plastics.

In order to attain the object described above, the present invention provides a film forming method, comprising: forming a film having at least one layer by a film forming process on a surface of a heat-resistant member having higher heat resistance than a substrate on which the film is to be formed, the film forming process including a step of performing at a temperature higher than a heat resistance temperature of the substrate; and thereafter transferring the film formed on the heat-resistant member to the surface of the substrate at a temperature less than the heat resistance temperature of the substrate.

Preferably, the film forming process as applied to the surface of the heat-resistant member includes a step of performing at a temperature of 80 °C or more.

Preferably, the film formed on the surface of the heat-resistant member is either a continuous film or a patterned film or both.

Preferably, film transfer from the heat-resistant member to the surface of the substrate is performed or is effected at least once.

Preferably, the film has a plurality of layers, the plurality of layers of the film are formed one layer by one layer on the surface of the heat-resistant member by repeating the film forming process to form the film and the film having the plurality of layers is thereafter transferred at once from the heat-resistant member to the surface of the substrate.

In order to attain the object described above, the present invention provides a film forming method, comprising: forming one layer in a plurality of layers of a film by a film forming process on a surface of a heat-resistant member having higher heat resistance than a substrate on which the film is to be formed, the film forming process including a step of performing at a temperature higher than a heat resistance temperature of the substrate; thereafter transferring the one layer formed on the heat-resistant member to the surface of the substrate at a temperature less than the heat resistance temperature of the substrate; and repeating the step of forming one layer in the plurality of layers of the film by the film forming process on the surface of the heat-resistant member or a surface of another heat-resistant member and the step of transferring the one layer from the heat-resistant member or the another heat-resistant member to a surface of at least one layer of the film transferred on the surface of the substrate to laminate the one layer to the surface of the at least one layer of the film, thereby forming the film having the plurality of layers on the surface of the substrate.

### BRIEF DESCRIPTION OF THE DRAWING

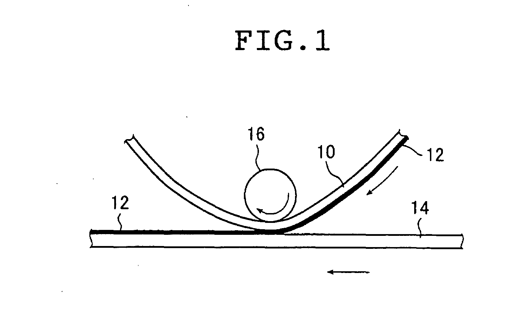

Fig. 1 shows in conceptual form an exemplary method of film transfer that can be employed in the film forming method of the invention.

### DETAILED DESCRIPTION OF THE INVENTION

On the following pages, the film forming method of the invention is described in detail.

According to the film forming method of the invention, films are formed on a variety of (film forming) substrates, particularly those of low heat resistance such as plastic films (which substrates are hereunder referred to conveniently as non-heat resistant substrates), under a high-temperature condition in excess of the withstand temperature of the non-heat resistant temperature or films are subjected to a treatment at a high temperature in excess of the same withstand temperature (the two kinds of film are hereunder referred to conveniently as films generated at high temperature) and this can be accomplished without any adverse effects due to heat in such a way that a film generated at high temperature is first formed on a surface of a heat-resistant member and then transferred to the non-heat resistant substrate.

The term "heat-resistant member" as used herein means any member that adequately resists the maximum temperature that may be encountered in the film forming process to be implemented.

Specifically, there can be employed a variety of members that are formed of a variety of metallic materials and metallic compounds, a variety of ceramic materials, heat-resistant resins such as aramids and polyimides, as well as glass, fabrics, leathers, wood, paper and paperboard.

The withstand temperature of the heat-resistant member is not limited to any particular value and a member having a high enough withstand temperature to develop adequate heat resistance may be chosen as appropriate for the maximum temperature that may be encountered in the film forming process to be implemented. A preferred heat-resistant member has a withstand temperature of at least 150 °C, with a particularly preferred value being at least 200 °C.

The term "withstand temperature" as applied to the heat-resistant member in the invention means a temperature beyond which a change that may adversely affect film formation, film quality or composition or film transfer to the non-heat resistant substrate occurs to the heat-resistant member.

Specific examples include the following: the melting point if the heat-resistant member is made of a metal; the decomposition temperature, denaturation temperature or ignition temperature if the heat-resistant member is made of a ceramic material; the glass transition point (Tg) if the heat-resistant member is made of glass; the glass transition point or decomposition temperature if the heat-resistant member is made of a heat-resistant resin; the decomposition temperature, denaturation temperature or ignition temperature if the heat-resistant member is made of glass, fabrics, leathers, wood, paper or paperboard.

The shape of the heat-resistant member is not limited in any particular way and any shape can be employed as long as it permits film transfer to the non-heat resistant substrate.

For instance, the heat-resistant member may be continuous (discrete) as exemplified by a plate, a sphere, a cylinder and a prism that have planar regions with film forming surfaces (i.e., transfer surfaces) of desired shapes. Alternatively, it may be a continuous member in web form such as a metal strip. It may also be a drum-shaped member or in the form of an endless belt. If the heat-resistant member is discrete, it may have a plurality of film forming surfaces on different sides.

As already noted, the film forming method of the invention comprises the steps of forming a film generated at high temperature on a surface of the heat-resistant member and transferring the film to the non-heat resistant substrate.

It therefore goes without saying that the heat-resistant member preferably permits smooth stripping of film and, to this end, the heat-resistant member is preferably optionally treated to improve the strippability of film from it.

One way to improve strippability is by directly forming a release layer on the film forming surface of the heat-resistant member prior to film formation and this can be done by coating, a vacuum film forming technique such as vacuum evaporation, plasma polymerization and the like. Examples of the release layer include a silicone layer, a fluoroplastic layer, a water repelling layer and a layer made of an inert material such as gold.

Alternatively, prior to film formation, the film forming surface of the heat-resistant member may be inactivated by subjecting it to a suitable treatment such as the formation of a carbon film.

Further, it is generally held that the lower the kinetic energy employed in vacuum film forming processes such as sputtering, the higher the strippability of the film that is formed. Hence, in the initial period of film formation by vacuum film forming processes, low enough energy may be applied to form a release undercoat on a surface of the heat-resistant member and subsequent film formation is performed using an amount of energy adapted for the film to be formed.

Other methods may of course be employed to improve film strippability from the heat-resistant member and they include: forming a metal oxide film on a surface of the heat-resistant member; and subjecting the surface of the heat-resistant member to corona discharge or other plasma surface treatment either in vacuum or in the atmosphere.

The term "non-heat resistant substrate" as used herein means any substrate on which the aforementioned film generated at high temperature is to be eventually formed.

Specific examples include a variety of resin (plastic) films including polyesters films such as polyethylene terephthalate and polyethylene terephthalate/isophthalate copolymer films, polyolefin films such as polyethylene, polypropylene and polypentene films, ethylene/vinyl alcohol copolymer films, and polycarbonate films. Other examples that can be employed include substrates formed of a variety of metals or metal compounds, a variety of ceramic materials, as well as fabrics, leathers, wood, paper, paperboard, etc.

The term "withstand temperature" as applied to the non-heat resistant substrate means a temperature beyond which melting, deformation, injury from thermal damage, etc. occurs to make it no longer useful as the film forming substrate or unable to yield the intended product.

Specific examples include the following: the glass transition point or decomposition temperature if the non-heat resistant substrate is made of a resin (or plastic); the melting point or decomposition temperature if the non-heat resistant substrate is made of a metal or a metallic compound; the glass transition point if the non-heat resistant substrate is made of glass; and the decomposition temperature, denaturation temperature or ignition temperature if the non-heat resistant substrate is made of a ceramic material, fabrics, leathers, wood, paper or paperboard.

The shape of the non-heat resistant substrate also is not limited in any particular way and a variety of shapes can be employed as appropriate for the use or the non-heat resistant substrate having a film formed thereon. The non-heat resistant substrate may be discrete or it may be a continuous substrate in web form such as a plastic film.

As already noted, the film forming method of the invention comprises the steps of forming a film generated at high temperature on a surface of the heat-resistant member and transferring the film to the non-heat resistant substrate.

It therefore goes without saying that the non-heat resistant substrate preferably permits good adhesion of film and, to this end, the non-heat resistant substrate is preferably optionally treated to improve its film adhesion.

To mention a few examples of the applicable surface treatment, exposure to electron beams, ozone treatment, corona discharge or glow discharge may be performed prior to transfer so as to activate a surface of the non-heat resistant substrate (to which the film formed is transferred).

Before the transfer step, an adhesive layer or a sticky layer may advantageously be formed on a surface of the non-heat resistant substrate. The adhesive or sticky agent to be employed may be chosen as appropriate for various factors including the type of the film to be transferred and the use of the non-heat resistant substrate on which the film has been formed.

On the following pages, the film forming method of the invention as it employs the above-described heat-resistant member and non-heat resistant substrate is described in detail.

In the first step of the film forming method of the invention, a film that is eventually to be formed on the non-heat resistant substrate is formed on a surface of the aforementioned heat-resistant member.

The film forming process is not limited in any particular way and a variety of methods may be employed.

Specifically, it may be a vacuum film forming process such as sputtering, vacuum evaporation, ion plating or CVD (chemical vapor deposition). Alternatively, it may be a wet film forming process comprising the steps of preparing a paint containing film forming materials, applying the paint to a surface of the heat-resistant member by a known technique such as spin coating, removing the solvent by drying, and curing the applied film by exposure to electron beams or uv radiation, sol/gel conversion or the like. If desired, these film forming processes may include a posttreatment such as annealing that can be applied to the film formed.

As already mentioned, it is preferred to perform an optional treatment for improving film strippability from the heat-resistant member.

Again, whether the vacuum film.forming process or the wet film forming process is adopted, highly crystalline, dense and high-quality films can more often be formed at high temperature rather than at low temperature.

Take, for example, the case of forming an indium-tin oxide film by sputtering; the preferred film forming temperature is between 150 °C and 450 °C. In the case of forming a Co-Cr based magnetic film, the preferred film forming temperature is between 100 °C and 300 °C.

These temperatures exceed the withstand temperatures of materials of low heat resistance such as ordinary plastic films; hence, it is extremely difficult to perform film formation on plastic films under those temperature conditions.

The film forming method of the invention is adapted for the process of film formation under high temperature conditions that exceed the withstand temperatures of such materials of low heat resistance. The invention process of forming a film on a surface of the heat-resistant member includes at least one step (of generating a film at high temperature) in which the surface temperature of the heat-resistant member exceeds the withstand temperature of the non-heat resistant substrate. Thus, according to the invention, film formation is possible at a temperature optimum for the film to be formed regardless of the withstand temperature of the non-heat resistant substrate on a surface of which the film is to be eventually formed.

The step in which a temperature develops in excess of the withstand temperature of the non-heat resistant substrate is not limited in any particular way. It may be a step that directly participates in film formation, as exemplified by the film forming step in the vacuum film forming process, or the coating step, drying step or sol/gel conversion step in the wet film forming process. Alternatively, it may be a step of post treatment after film formation such as annealing, or it may be all steps in the film forming process. In other words, at least one step of generating a film at high temperature may be included in the film forming process which begins with the start of film formation and ends with the completion of the intended film.

Note that the film to be formed in the invention is not limited in any particular way and any film that is adapted for a specific use may be formed. However, considering such factors as the ability to exhibit the advantages of the invention to the fullest extent, a preferred film forming process is such that it needs to include a step at a high temperature of at least 80 °C, particularly at least 150 °C, in order to produce high-quality films.

After the film generated at high temperature is formed on a surface of the heat-resistant member, it is then transferred to the non-heat resistant substrate. As already mentioned, in order to perform this transfer step advantageously, the non-heat resistant substrate is preferably subjected to a treatment for improving its adhesion to film.

Thus, according to the invention, a film generated at high temperature is first formed on the heat-resistant member and then transferred to the non-heat resistant substrate. In this way, the film generated at high temperature which is optimum for use, composition, etc. can be efficiently formed on the non-heat resistant substrate such as plastic films of low heat resistance.

The method of transferring the film generated at high temperature is not limited in any particular way and a variety of compressive transfer methods may be adopted considering the shapes of the heat-resistant member and non-heat resistant substrate. If desired, heat may be applied during transfer (thermal transfer), provided that the heating temperature does not exceed the withstand temperature of the non-heat resistant substrate.

An exemplary transfer step is depicted in Fig. 1 with respect to the case where a film 12 formed on a surface of a heat-resistant member 10 in web form is transferred to a non-heat resistant substrate 14 which is also in web form. The heat-resistant member 10 and the non-heat resistant substrate 14 are transported in the same direction (indicated by the arrows), with the film carrying side of the heat-resistant member 10 being in a face-to-face relationship with the side of the non-heat resistant substrate 14 to which the film is to be transferred, and the heat-resistant member 10 is compressed to the non-heat resistant substrate 14 by means of a pressure roller 16 rotating in the same direction, whereupon the film 12 formed on the surface of the heat-resistant member 10 is transferred to the non-heat resistant substrate 14. If thermal transfer is to be performed, the pressure roller 16 may be heated.

The film to be formed on the non-heat resistant substrate in the film forming method of the invention may be continuous throughout or it may be a patterned film. In the latter case, the pattern to be formed is not limited in any particular way; it may be a repeated pattern or different patterns may be interconnected or the two types of pattern may be combined.

In one method of patterned film formation, a patterned film is first formed on a surface of the heat-resistant member by a known technique that employs a mask and photolithography and then transferred to the non-heat resistant substrate. Alternatively, asperities are formed on the surface of the film carrying side of the heat-resistant member in conformity with the desired film pattern and the film on the ridges is transferred to the non-heat resistant substrate, whereby a patterned film is formed on it.

In the film forming method of the invention, the film to be formed on the non-heat resistant substrate may be single- or multi-layered. In order to form a multi-layered film, it may first be formed on a surface of the heat-resistant member and then transferred to the non-heat resistant substrate. Alternatively, a single-layered or multi-layered film formed on a surface of the heat-resistant member may be transferred a plurality of times in order to form a multi-layered film on the non-heat resistant substrate. If desired, these methods may be combined to form a multi-layered film on the non-heat resistant substrate.

In yet another approach, the relative positions of the heat-resistant member and non-heat resistant substrate may be moved each time film transfer is effected, whereby film transfer is performed a plurality of times in different positions on a single non-heat resistant substrate. In this case, the film transferred to the non-heat resistant substrate may consist of spaced segments or it may be continuous; alternatively, one part of the film may be transferred in overlap with another part or a mixture of these embodiments may be adopted.

While the d film forming method of the invention has been described above in detail, it should be understood that the invention is by no means limited to the foregoing examples and various improvements and modifications may of course be made without departing from the spirit and scope of the invention.

In the example shown in Fig. 1, a film is first formed on a web of heat-resistant member and then transferred to a web of non-heat resistant substrate. This is not the sole case of the invention and the heat-resistant member and the non-heat resistant substrate may be combined in various other ways; for instance, a discrete heat-resistant member may be combined with a discrete non-heat resistant substrate or, alternatively, film may be transferred from a discrete heat-resistant member to a web of non-heat resistant substrate. Conversely, film may be transferred from a web of heat-resistant member to a discrete non-heat resistant substrate.

The following specific examples are provided to further illustrate the film forming method of the invention but are in no way to be taken as limiting.

### <Transparent electrode substrate a (invention sample)>

### [Preparing a transfer substrate]

A polyimide (PI) film having a thickness-of 50 µm and measuring 100 mm x 100 mm was used as a heat-resistant member. It had a withstand temperature of about 250 °C.

The heat-resistant member was dip coated on one side (which is hereunder referred to as the obverse surface) with OPTOOL (product of DAIKIN INDUSTRIES, LTD.) and the applied coat was dried to form a release fluororesin layer in a thickness of about 20 nm, thereby making the heat-resistant member water repellent.

The heat-resistant member was then fitted on a substrate holder in a sputtering apparatus. As the substrate holder was heated at 210 °C with a sheathed heater, dc magnetron sputtering was performed on an indium-tin oxide target (10 wt% Sn) to form a transparent electrode layer (ITO layer) in a thickness of about 130 nm. On the following description, the heat-resistant member carrying the ITO layer is conveniently referred to as a "transfer substrate".

The ITO layer was formed in an Ar atmosphere with 0.75 vol% O₂ at a dc power of 1 kW and a deposition pressure of 0.4 Pa. According to an x-ray analysis, the ITO layer showed crystallinity peaks at (222) and (400). It also had a resistance of 20 ohms per square.

### [Preparing a non-heat resistant substrate]

A TAC (triacetyl cellulose) film having a thickness of 80 µm and measuring 100 mm x 100 mm was used as a non-heat resistant substrate. This film had a glass transition point of 120 °C.

The non-heat resistant substrate was coated on one side (which is hereunder referred to as the obverse surface) with a hard coating (DPHA of NIPPON KAYAKU CO., LTD.) having 15-nm SiO₂ particles being dispersed in an amount of 20 wt%; the applied coat was dried at 100 °C for 2 minutes and then exposed to uv radiation so that it cured to form a hard coating layer in a thickness of about 3 µm. The hard coating layer had a refractive index of 1.51.

The non-heat resistant substrate carrying the hard coating layer was set in a vacuum chamber, which was evacuated to 1 x 10⁻³ Pa and degassed for 3 minutes after heating to 80 °C with an ir heater. Thereafter, Ar gas was introduced until the pressure in the system increased to 2 Pa and a plasma treatment was performed for 1 minute with a power of 0.7 kW so as to modify the surface of the hard coating layer. In this way, the non-heat resistant substrate was prepared for transfer of the ITO layer from the separately prepared transfer substrate.

### [Fabricating transparent electrode substrate a]

The thus prepared transfer substrate and non-heat resistant substrate were placed one on top of the other with their obverse surfaces facing each other. The assembly was passed through a hot (100 °C) roller pair at a pressure of 0.3 Mpa and at a speed of 0.03 m/min to compress it thermally. Thereafter, the transfer substrate was detached from the non-heat resistant substrate to fabricate transparent electrode substrate a having the ITO layer formed on the non-heat resistant substrate.

### <Transparent electrode substrate b (comparative sample)>

A non-heat resistant substrate was prepared as in the case of the transparent electrode substrate a.

On a side of this non-heat resistant substrate, an ITO layer was formed in a thickness of about 130 nm by repeating the procedure for preparing the transfer substrate in the case of the transparent electrode substrate a, except that the substrate heating temperature was lowered to 100 °C. In this way, transparent electrode substrate b was fabricated.

### <Transparent electrode substrate c (invention sample)>

Transparent electrode substrate c was fabricated by repeating the procedure for fabricating the transparent electrode substrate a, except that the hard coating layer formed on the non-heat resistant substrate was not subjected to surface modification (plasma treatment).

### <Transparent electrode substrate d (invention sample)>

Transparent electrode substrate d was fabricated by repeating the procedure for fabricating the transparent electrode substrate a, except that in the preparation of the transfer substrate, the heat-resistant member was not rendered water repellent.

### <Transparent electrode substrate e (invention sample)>

Transparent electrode substrate e was fabricated by repeating the procedure for fabricating the transparent electrode substrate a, except that in the preparation of the transfer substrate, the treatment for rendering the heat-resistant member water repellent was replaced by the formation of a gold (Au) layer about 30 nm thick on the obverse surface of the heat-resistant member.

The gold layer was formed by vacuum evaporation in which the ultimate degree of vacuum was 5 x 10⁻⁴ Pa and the deposition rate was 1 nm/sec.

### <Transparent electrode substrate f (invention sample)>

Transparent electrode substrate f was fabricated by repeating the procedure for fabricating the transparent electrode substrate a, except that the PI film as the heat-resistant member for the transfer substrate was replaced by a white, smooth-surfaced flat glass 3 mm thick that measured 100 mm x 100 mm and which had a maximum surface roughness (Rₘₐₓ) of 0.5 nm.

### <Transparent electrode substrate g (invention sample)>

Transparent electrode substrate g was fabricated by repeating the procedure for fabricating the transparent electrode substrate a, except that in the preparation of the transfer substrate, the substrate holder was not heated (for heating the substrate) during the formation of the ITO layer but that the film as formed was subjected to annealing at 210 °C for 30 minutes.

### <Transparent electrode substrate h (invention sample)>

Transparent electrode substrate h was fabricated by repeating the procedure for fabricating the transparent electrode substrate a, except that the PI film as the heat-resistant member for the transfer substrate was replaced by an aluminum foil 50 µm thick that measured 100 mm x 100 mm.

### <Evaluation of the transparent electrode plates>

The thus fabricated transparent electrode substrates a - h were evaluated for electrical resistance, crystallinity, adhesion and surface properties.

Using an ohmmeter, the surface resistance of the ITO layer was measured at the center of the 100 mm x 100 mm area, as well as at four points that were away from the center by 30 mm both vertically and horizontally. The samples that showed surface resistances of 20 ohms per square and less at all points of measurement were rated "o", those showing values greater than 20 ohms per square at all points of measurement were rated "x", and those having both levels of resistance were rated "Δ".

For evaluating crystallinity, the ITO layer was subjected to x-ray analysis and the samples showing crystallinity peaks at (222) and (400) were rated "O" and the others were rated "x".

Adhesion was evaluated by a tape peel test. The samples that showed no visible detachment of the ITO layer were rated "o", those which showed visible detachment of the ITO layer in limited areas (5% or less) were rated "Δ", and the other samples were rated "x".

To evaluate surface properties, the entire surface of the ITO layer was examined with an optical microscope at a plurality of magnifications in the range of 50 - 1,000; the samples that had no defects throughout such as failures in transfer and cracks were rated "o", those which had partial defects with a total area of less than 5% were rated "Δ", and the other samples were rated "x".

The samples were also subjected to overall rating according to the following criteria: "o", given the rating "o" in all of the four items; "Δ", given both ratings "o" and "Δ" but not the rating "x"; "x", given the rating "x" in any one of the four items.

The conditions for forming the transparent electrode substrates are set forth in Table 1 below and the results of evaluation in Table 2.

**Table 1.**

| Transparent electrode substrate No. | Transfer substrate | | Plazma treatment of non-heat resistant substrate | ITO heating conditions |
|---|---|---|---|---|
| | substrate | Surface treatment | | |
| a | PI | For rendering water repellent | yes | 210 °C |
| b | No transfer | | ↓ | 100 °C |
| c | PI | For rendering water repellent | no | 210 °C |
| d | ↓ | no | yes | ↓ |
| e | ↓ | gold | ↓ | ↓ |
| f | glass | for rendering | ↓ | ↓ |
| g | PI | ↓ | ↓ | 210 °C |
| h | aluminum foil | ↓ | ↓ | 210 °C |
| i | PI roll | ↓ | ↓ | ↓ |
| j | PI roll used again | ↓ | ↓ | ↓ |

**Table 2.**

| Transparent electrode substrate No. | Evaluations of film | | | | Overal rating |
|---|---|---|---|---|---|
| | resistance | Crystallinity | adhesion | Surface properties | |
| a | o | o | o | o | o |
| b | x | x | o | Δ | x |
| c | o | o | Δ | Δ | Δ |
| d | o | o | o | Δ | Δ |
| e | o | o | o | o | o |
| f | o | o | o | o | o |
| g | o | o | o | o | o |
| h | o | o | o | Δ | Δ |
| i | o | o | o | o | o |
| j | o | o | o | o | o |

### <Transparent electrode substrates i and j>

Transparent electrode substrate i was fabricated by repeating the procedure for fabricating the transparent electrode substrate a, except that the PI film as the heat-resistant member for the transfer substrate was replaced by a PI film roll having a thickness of 50 µm, a width of 250 mm and a length of 10 m and that a TAC film roll having a thickness of 80 µm, a width of 250 mm and a length of 10 m was used as the non-heat resistant substrate.

Transparent electrode substrate j was fabricated by repeating the procedure for fabricating the transparent electrode substrate i, except that the PI film which was used once to fabricate the transparent electrode i was used again as the heat-resistant member for the transfer substrate without being subjected to any treatment.

The two transparent electrode substrates were evaluated for electrical resistance, crystallinity, adhesion and surface properties by the same methods as employed to evaluate the transparent electrode substrates a - h, except that measurements were conducted at ten points, five of which were spaced apart in the longitudinal direction at intervals of 2 m and aligned on a line parallel to the longer sides of the substrate and 50 mm distant from one of the longer sides in the direction of width, and the other five being also spaced apart in the longitudinal direction at intervals of 2 m and aligned on a parallel line 150 mm distant from said one longer side in the direction of width.

The results of evaluations are also shown in Table 2, from which it is clear that either of the transparent electrode substrates i and j displayed as satisfactory performance as the transparent electrode substrate a.

As one can see from the foregoing results, according to the present invention, thin films that require or prefer generation at high temperature (e.g. film formation or post treatment at high temperature) can be formed, while securing sufficient smoothness, on films that do not have sufficient heat resistance or those which do not have satisfactory surface smoothness. If the thin film to be formed is an ITO film, a film that has been formed at high temperature and/or has been subjected to annealing and which has not only low electrical resistance and good crystallinity but also high degree of surface smoothness can be formed on any substrates that have only insufficient heat resistance.

If the heat-resistant member and the non-heat resistant substrate are in strip form and flexible, the invention ensures that the process of thin film formation including generation at high temperature on such non-heat resistant substrate can be accomplished with high productivity by the roll-to-roll method.

Further, if the heat-resistant member on which thin films are to be formed by generation at high temperature is given better releasing property by, for example, being rendered water repellent, thin films that have been generated at high temperature can be formed on any substrates having only insufficient heat resistance with better transferability and productivity.

The advantages of the inventicn are therefore clear from the foregoing results.

As described above in detail, according to the film forming method of the invention, films that have been generated under high temperature conditions or which have been subjected to a post treatment such as annealing at high temperature can efficiently be formed on a surface of plastic films and other substrates of low heat resistance without causing any thermal damage.

## Claims

1. A film forming method, comprising:
forming a film having at least one layer by a film forming process on a surface of a heat-resistant member having higher heat resistance than a substrate on which said film is to be formed, said film forming process including a step of performing at a temperature higher than a heat resistance temperature of said substrate; and
thereafter transferring said film formed on said heat-resistant member to said surface of said substrate at a temperature less than said heat resistance temperature of said substrate.

2. The film forming method according to claim 1, wherein said film forming process as applied to said surface of said heat-resistant member includes a step of performing at a temperature of 80 °C or more.

3. The film forming method according to claim 1 or 2, wherein said film formed on said surface of said heat-resistant member is either a continuous film or a patterned film or both.

4. The film forming method according to any one of claims 1 to 3, wherein film transfer from said heat-resistant member to said surface of said substrate is performed at least once.

5. The film forming method according to any one of claims 1 to 4, wherein
said film has a plurality of layers,
said plurality of layers of said film are formed one layer by one layer on said surface of said heat-resistant member by repeating said film forming process to form said film, and
said film having said plurality of layers is thereafter transferred at once from said heat-resistant member to said surface of said substrate.

6. A film forming method, comprising:
forming one layer in a plurality of layers of a film by a film forming process on a surface of a heat-resistant member having higher heat resistance than a substrate on which said film is to be formed, said film forming process including a step of performing at a temperature higher than a heat resistance temperature of said substrate;
thereafter transferring said one layer formed on said heat-resistant member to said surface of said substrate at a temperature less than said heat resistance temperature of said substrate; and
repeating said step of forming one layer in said plurality of layers of said film by said film forming process on said surface of said heat-resistant member or a surface of another heat-resistant member and said step of transferring said one layer from said heat-resistant member or said another heat-resistant member to a surface of at least one layer of said film transferred on said surface of said substrate to laminate said one layer to said surface of said at least one layer of said film, thereby forming said film having said plurality of layers on said surface of said substrate.
